Europäisches Patentamt

European Patent Office

Office européen des brevets

(11) Numéro de publication: **0 347 985 B1**

# FASCICULE DE BREVET EUROPEEN

(45) Date de publication de fascicule du brevet: **09.02.94** (51) Int. Cl.5: **H03H 11/18**

(21) Numéro de dépôt: **89201554.6**

(22) Date de dépôt: **15.06.89**

(54) **Circuit actif hyperfréquences du type passe-tout.**

(30) Priorité: **21.06.88 FR 8808300**

(43) Date de publication de la demande:
**27.12.89 Bulletin 89/52**

(45) Mention de la délivrance du brevet:
**09.02.94 Bulletin 94/06**

(84) Etats contractants désignés:
**DE FR GB IT**

(56) Documents cités:
**US-A- 4 525 680**

**IEEE TRANSACTIONS ON MICROWAVE THEORY AND TECHNIOUES, vol. MTT-34, no. 12, décembre 1986, pages 1533-1537, IEEE, New York, US; S.K. ALTES et al.: "Monolithic RC all-pass networks with constant-phase-difference outputs"**

**1982 IEEE MTT-S INTERNATIONAL MICROWAVE SYMPOSIUM DIGEST, Dallas, Texas, 15-17 juin 1982, pages 162-165, IEEE, New York, US; A.M. PAVIO: "A network modeling and design method for a 2-18 GHz feedback amplifier"**

(73) Titulaire: **LABORATOIRES D'ELECTRONIOUE ET DE PHYSIOUE APPLIOUEE L.E.P.**
**3, Avenue Descartes**
**F-94450 Limeil-Brévannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB IT**

(72) Inventeur: **Francheteau, Philippe**
**Société Civile S.P.I.D.**
**209 rue de l'Université**
**F-75007 Paris(FR)**
Inventeur: **Pyndiah, Ramesh**
**Société Civile S.P.I.D.**
**209 rue de l'Université**
**F-75007 Paris(FR)**

(74) Mandataire: **Landousy, Christian et al**
**Société Civile S.P.I.D.**
**156, Boulevard Haussmann**
**F-75008 Paris (FR)**

**1983 IEEE MTT-S INTERNATIONAL MICROWA-VE SYMPOSIUM DIGEST, Boston, Massachu-setts, 31 mai - 3 juin 1983, pages 50-53, IEEE, New York, US; V. PAUKER et al.: "Mideband high gain small size monolithic GaAs FET amplifiers"**

**Description**

L'invention concerne un circuit actif hyperfréquences du type passe-tout, comprenant un étage amplificateur et un réseau R-C.

L'invention trouve son application dans la réalisation de mélangeurs à réjection de fréquence image destinés, par exemple à des têtes de réception de signaux retransmis par satellites artificiels ou de signaux hertziens en général. L'invention trouve aussi son application dans la réalisation de modulateurs quatre phases et plus.

Un circuit déphaseur est connu de la publication intitulée : "Monolithic RC All-Pass Networks with Constant-Phase-Difference Outputs" par Stephen K. ALTES et alii dans "IEEE Transactions on Microwave Theory and Techniques, VOL. MTT-34, N°12, December 1986, p.1533-1537".

Ce document décrit un circuit déphaseur réalisé à partir d'un circuit R-C, comprenant d'abord deux transistors à effet de champ montés en buffer pour abaisser l'impédance de sortie de l'étage qui précède le réseau R-C. Chacun de ces transistors a son drain relié directement à une tension d'alimentation continue, sa source reliée à la masse à travers une résistance et présente une largeur de grille importante (120 $\mu$m). Chaque transistor reçoit sur sa grille un signal d'entrée qui présente la même amplitude que celle du signal reçu par l'autre transistor mais qui est en opposition de phase.

La source de chacun des transistors est reliée aussi à l'une des extrémités d'un circuit formé de quatre branches en parallèle. Chaque branche est constituée par un réseau R-C série. Les sorties du circuit déphaseur se font au point commun à la capacité et à la résistance de chaque branche. Les résistances et les capacités de chaque branche sont prévues pour que chaque sortie présente par rapport à la suivante la même amplitude et un déphasage de 90°. Un circuit interrupteur est en outre prévu pour basculer d'un couple de sorties sur un autre.

Ce circuit fonctionne dans la bande 220-280 Hz, ce qui est beaucoup trop bas en fréquences pour les applications envisagées de la présente invention, ces applications nécessitant un déphaseur fonctionnant au moins dans la bande 8-12 GHz.

La publication citée présente un second circuit fonctionnant dans la bande 3-5 GHz. Mais ce domaine de fréquences est encore trop bas pour les applications envisagées. Ce résultat est atteint dans ce second circuit, du fait qu'il est prévu du second ordre, ce qui est obtenu en ajoutant un certain nombre de composants. Or un grand nombre de composants est toujours défavorable à l'intégration à grande échelle qui est recherchée.

De plus les circuits du second ordre présentent des pertes d'insertion importantes par rapport aux circuits du premier ordre.

Par ailleurs son fonctionnement est fondé sur le même principe que le circuit précédent.

Il est important de comprendre que dans les circuits connus, l'impédance de charge de ces circuits (ou impédance d'entrée du circuit suivant) entre dans la fonction de transfert de façon telle que le module de cette fonction de transfert dépend d'une constante de temps dans laquelle intervient cette impédance, et de la fréquence. La fonction de transfert est ainsi celle d'un passe-tout non-idéal.

Pour que le(les) circuit(s) connu(s) présente(nt) une fonction de transfert aussi proche que possible de la fonction passe-tout idéale, il faut que deux conditions soient remplies à la fois. Il faut d'abord que les impédances de sortie des transistors montés en buffer soient faibles devant la résistance du réseau R-C. Il faut ensuite que l'impédance d'entrée de l'étage suivant soit forte devant l'impédance de la capacité du réseau R-C.

Les impédances de ces étages précédent et suivant étant fixes, la fonction de transfert du (des) circuit-(s) connu(s) ne peut jamais être celle d'un passe-tout idéal, et ceci est de plus en plus sensible lorsque la fréquence augmente.

D'autre part dans chacun des réseaux R-C, la valeur de la capacité et de la résistance est fixée pour obtenir une constante de temps différente, permettant d'obtenir le déphasage voulu sur chaque voie. De ceci, il résulte tout d'abord que le gain sur chaque voie est différent. Il résulte ensuite que, lorsque l'on désire augmenter la fréquence de fonctionnement, il faut diminuer les produits R-C pour diminuer les constantes de temps. Or on a vu précédemment que la valeur de la résistance et de la capacité des réseaux R-C doit être maintenue dans certaines limites imposées par les impédances des circuits précédent et suivant, pour rester aussi proche que possible de la fonction passe-tout idéale.

Dans ces conditions, le(s) circuit(s) connu(s) restent limités à des fréquences relativement basses, ou bien ils montrent très vite des performances dégradées en amplitude et en phase.

Il est aussi important de comprendre que le(s) circuit(s) connu(s) nécessitent toujours deux signaux d'entrée de même amplitude et en opposition de phase. D'une part, la génération de ces signaux à partir d'un signal nécessite l'adjonction d'un circuit supplémentaire, ce qui augmente la surface du circuit et sa

EP 0 347 985 B1

consommation. D'autre part, il est très difficile d'obtenir des signaux rigoureusement de même amplitude et en opposition de phase.

Un des buts de l'invention est donc de fournir un circuit actif passe-tout qui présente une fonction de transfert de passe-tout idéale.

Ce but est atteint au moyen d'un circuit actif du type R-C tel que décrit dans le préambule et caractérisé en ce que l'étage amplificateur comprend d'abord un étage inverseur formé par un transistor à effet de champ $Q_1$ monté en inverseur, sur la grille duquel un signal d'entrée hyperfréquences $V_E$ est appliqué à travers une résistance R constituant la résistance du réseau R-C, et dont la capacité grille-source $C_{GS}$ est utilisée pour constituer la capacité C du réseau R-C, en ce que l'étage amplificateur comprend ensuite une branche de contre-réaction montée entre l'entrée hyperfréquences $V_E$ et la sortie hyperfréquences $V_S$ de l'étage inverseur, cette branche de contre-réaction incluant une résistance $R_O$ et une ligne de transmission $L_O$, et en ce que les caractéristiques des éléments de ce circuit, pour obtenir une fonction de transfert de passe-tout idéal, sont liés par les conditions :

a) $Z = R_0$

b) $\ell = v\tau$

c) $R_0 = 2/G_{MO}$

où Z est l'impédance caractéristique de la ligne $L_O$

$\ell$ est sa longueur physique,

v est la vitesse de phase,

$\tau$ est le temps de transit des électrons sous la grille du transistor inverseur $Q_1$

et $G_{MO}$ est la transconductance du transistor inverseur $Q_1$.

Dans ces conditions, le circuit selon l'invention peut notamment atteindre des fréquences de l'ordre de 12 GHz ou 18 GHz selon la technologie employée pour sa réalisation.

Dans une mise en oeuvre du circuit, ce dernier est caractérisé en ce que la capacité grille-source $C_{GS}$ du transistor $Q_1$ et la résistance R sont en outre prévues pour fournir une constante de temps $\tau_1$ du circuit apte à produire un déphasage de 45° entre l'entrée hyperfréquences $V_E$ et la sortie hyperfréquences $V_{S1}$ disponible sur le drain du transistor inverseur $Q_1$.

Dans une autre mise en oeuvre du circuit, ce dernier est caractérisé en ce que la capacité grille-source $C_{GS}$ du transistor $Q_1$ et la résistance R sont en outre prévues pour fournir une constante de temps $\tau_2$ du circuit apte à produire un déphasage de 135° entre l'entrée hyperfréquences $V_E$ et la sortie hyperfréquences $V_{S2}$ disponible sur le drain du transistor $Q_1$.

Un des buts de l'invention est aussi de fournir un déphaseur actif 0-90° qui fonctionne en hyperfréquences à partir d'un seul signal d'entrée, et qui présente des performances élevées en écart d'amplitude et en écart de phase.

Selon l'invention, un circuit déphaseur pour fournir, à partir d'un seul signal d'entrée hyperfréquences $V_E$, deux signaux de sortie hyperfréquences $V_{S1}$ et $V_{S2}$ présentant la même amplitude et un déphasage de 90°, est constitué d'un circuit passe-tout selon la première mise en oeuvre couplé par l'entrée $V_E$ à un circuit passe-tout selon la seconde mise en oeuvre.

Dans ces conditions, ce circuit déphaseur fonctionne aux fréquences très élevées précédemment citées, mais aussi il fournit des signaux de sortie de même amplitude avec une précision de ± 0,1 dB, et dont la différence de phase est de 90° avec une précision de ± 0,6°, le tout à partir d'un seul signal d'entrée.

Un des buts de l'invention est encore de fournir un circuit passe-tout et un circuit déphaseur, qui puissent être intégrés, par exemple sur arséniure de gallium, matériau semiconducteur particulièrement favorable aux réalisations hyperfréquences, de manière telle que ces circuits puissent être en synergie de fabrication avec d'autres circuits hyperfréquences.

Dans une mise en oeuvre préférentielle, ces circuits sont réalisés au moyen de transistors à effet de champ du type MESFET pour une fréquence maximale de fonctionnement de l'ordre de 12 GHz, et au moyen de transistors à effet de champ du type HEMT pour une fréquence maximale de fonctionnement de l'ordre de 18 GHz, et intégrés avec les autres éléments sur arséniure de gallium (GaAs).

L'invention sera mieux comprise au moyen de la description suivante illustrée par les figures annexées dont :

- la figure 1a qui représente schématiquement une cellule passe-tout R-C selon l'invention,
- la figure 1b qui représente le circuit équivalent au circuit de la figure 1a,
- la figure 2 qui représente un circuit déphaseur 0-90° constitué de deux cellules passe-tout selon la figure 1, admettant le même signal d'entrée,
- la figure 3a qui représente en fonction de la fréquence f(GHz) la différence d'amplitude ΔA (en $10^{-2}$dB) et la différence de phase Δ$\phi$ en degrés, pour une valeur de la résistance $R_0$ de contre-

4

EP 0 347 985 B1

réaction optimale,
- la figure 3b qui représente les mêmes variables pour une valeur de la résistance $R_0$ de contre-réaction inférieure à la valeur optimale,
- la figure 3c qui représente les mêmes variables pour une valeur de la résistance $R_0$ de contre-réaction supérieure à la valeur optimale,
- la figure 4a qui représente les variations de l'amplitude et de la phase de l'impédance d'entrée $Z_I$ du circuit déphaseur réalisé au moyen de transistors HEMT, en fonction de la fréquence,
- les figures 4b et 4c qui représentent respectivement les variations de l'amplitude et de la phase des impédances de sorties $Z_{S1}$ et $Z_{S2}$ des sorties du circuit déphaseur réalisé au moyen de transistors HEMT, en fonction de la fréquence.

Pour les applications aux hyperfréquences envisagées, le circuit passe-tout selon l'invention, et le circuit déphaseur formé à partir de ce circuit passe-tout, sont réalisés au moyen de transistors à effet de champ, sur un substrat semiconducteur du groupe III-V, par exemple sur arséniure de gallium (GaAs).

La figure 1a représente schématiquement la cellule passe-tout selon l'invention. Cette cellule comprend d'une part un étage inverseur formé du transistor inverseur $Q_1$ et d'une charge $Q_3$. Le drain du transistor inverseur $Q_1$ est porté à une tension d'alimentation continue $V_{DD}$ à travers la charge $Q_3$ et sa source est reliée directement à la masse.

Le transistor $Q_1$ montre une capacité grille-source notée $C_{GS}$.

Cette cellule comprend d'autre part un réseau R-C formé de la résistance R dont une extrémité est reliée à la grille du transistor inverseur $Q_1$ et dont l'autre extrémité est reliée à l'entrée hyperfréquences $V_E$ du circuit, et formé de la capacité grille-source $C_{GS}$ du transistor $Q_1$.

Ce réseau R-C étant appliqué sur l'entrée de la cellule passe-tout selon l'invention, la fonction de transfert de cette dernière ne dépend pas de l'impédance de sortie de l'étage précédent, comme cela était le cas dans les circuits connus de l'état de la technique.

La charge $Q_3$ est formée de préférence d'un transistor à effet de champ dont la grille est polarisée à travers une résistance $R_A$ par une tension continue $V_3$, dont la drain est porté directement à la tension d'alimentation continue $V_{DD}$ et dont la source est reliée au drain du transistor inverseur $Q_1$, constituant le noeud de sortie 1 de la cellule, sur lequel est disponible le signal de sortie $V_S$. La grille du transistor de charge $Q_3$ est en outre reliée à sa source à travers une capacité $C_1$.

Selon l'invention, l'étage décrit précédemment est monté en amplificateur à contre-réaction au moyen d'une branche placée entre l'entrée $V_E$ au noeud 4 et la sortie $V_S$, au noeud 1. Cette branche comprend une résistance $R_0$ et une ligne $L_0$ montées en série.

Cette branche de contre-réaction est isolée de l'entrée 2 $V_E$ par une capacité $C_2$ placée entre les noeuds 2 et 4 et de la branche R-$C_{GS}$ par une capacité $C_3$ placée entre les noeuds 4 et 3. D'autre part, la grille du transistor inverseur $Q_1$ est polarisée par une tension continue $V_1$ à travers une résistance $R_B$ placée entre $V_1$ et l'extrémité de la résistance R du réseau R-$C_{GS}$ au noeud 3.

Les tensions de polarisation $V_1$ et $V_3$ sont prévues variables pour permettre l'ajustement de l'amplitude et de la phase du signal de sortie $V_S$.

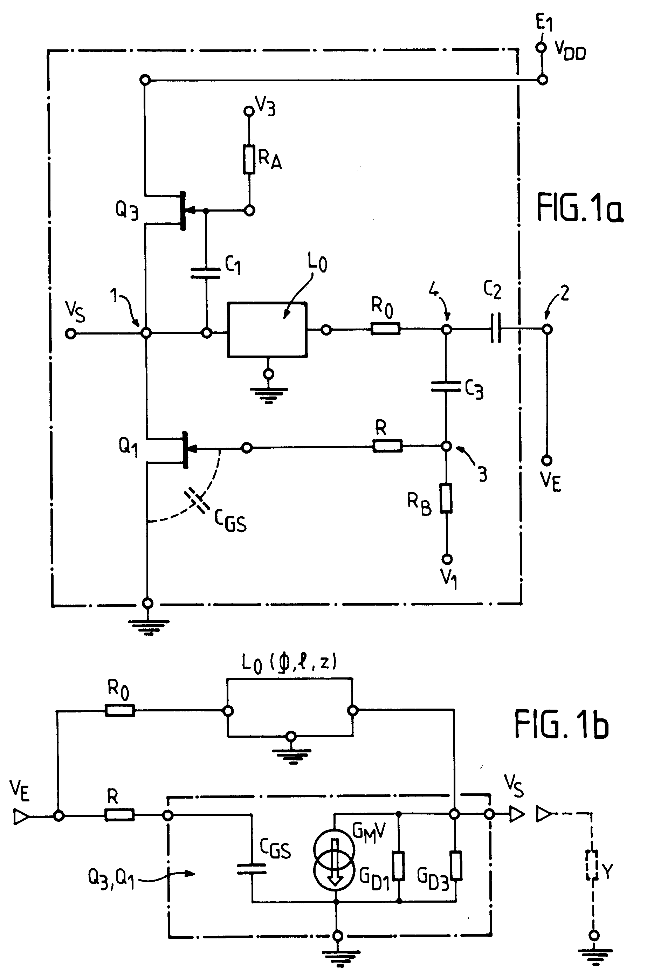

Pour obtenir la fonction de transfert d'un passe-tout idéal, des conditions sont imposées aux éléments de la cellule, conditions qui seront mieux comprises en considérant, en même temps que le schéma de la figure 1a, le schéma équivalent de ce circuit, représenté sur la figure 1b.

la ligne $L_0$ est caractérisée par sa longueur physique $\ell$, par sa longueur électrique $\phi$ donnée par la relation 1 du tableau I, où $\beta$ est la constante de propagation guidée de la ligne, où f est la fréquence de fonctionnement et v est la vitesse de phase, et caractérisée par son impédance caractéristique Z ;

Y est la charge constituée par l'admittance d'entrée de l'étage (ou circuit) suivant la cellule passe-tout ;

$G_{D1}$ et $G_{D3}$ sont les conductances drain-source des transistors $Q_1$ et $Q_3$ respectivement et $G_D$ leur conductance équivalente ;

$G_{MO}$ est la transconductance du transistor $Q_1$, et $\tau$ est le temps de transit des porteurs sous la grille de ce transistor, d'où il résulte que la transconductance $G_M$ de l'étage inverseur est donnée par la relation 2 du tableau I.

Dans ces conditions la fonction de transfert de la cellule unitaire passe-tout de la figure 1a est donnée par la relation 3 du tableau I, relation dans laquelle on a écrit $C_{GS}$ = C pour simplifier l'écriture.

On choisira comme première condition de réaliser $R_0$ = Z (condition a). La fonction de transfert de la cellule passe-tout s'écrit alors plus simplement sous la forme de la relation (4) du tableau I.

La condition a est remplie lorsque l'impédance caractéristique Z de la ligne $L_0$ est choisie égale à la résistance $R_0$ de la branche de contre-réaction.

On choisira comme seconde condition que

$\phi = \omega\tau$ (sachant que $\omega = 2\pi f$)

5

Alors, la relation 1) du tableau I conduit à écrire cette seconde condition sous la forme :

$\ell = \tau V$      condition b.

La condition b est remplie lorsque la longueur physique de la ligne $L_0$ engendre un retard qui compense le retard du signal entre l'entrée et la sortie de l'étage inverseur.

On choisira comme troisième condition

$R_0 = 2/G_{MO}$      condition c

La condition c est remplie lorsque, en outre, la résistance $R_0$ de la branche de contre-réaction est choisie de valeur deux fois l'inverse de la transconductance du transistor inverseur $Q_1$.

La fonction de transfert de la cellule unitaire passe-tout selon l'invention s'écrit alors sous la forme de la relation 5) du tableau I.

Comme le montre la relation 5) du tableau I la fonction de transfert $F(j\omega)$ s'écrit sous la forme de la fonction d'un passe-tout idéal (voir le terme 6) du tableau I) que multiplie une constante indépendante de la valeur de la résistance R et de la capacité C du réseau R-C (voir le terme 7) du tableau I).

Dans ces conditions, l'amplitude de $F(j\omega)$ dépend certes de la fréquence, mais elle ne dépend pas de la valeur de R et de C, autrement dit l'amplitude du signal de sortie ne dépend pas de la constante de temps du réseau R-C.

Le circuit comprend un seul élément parasite qui est la capacité grille-drain du transistor inverseur $Q_1$. Mais cet élément est de peu d'importance, car cette capacité grille-drain est très faible devant la capacité grille-source du transistor à effet de champ.

La capacité grille-drain est donc pratiquement court-circuitée par la capacité grille-source.

La capacité grille-source $C = C_{GS}$ du transistor $Q_1$ est une fonction de la dimension de ce transistor. Pour augmenter la fréquence de fonctionnement du circuit, on peut soit diminuer la taille du transistor inverseur $Q_1$, soit diminuer la résistance R du réseau R-C, ce qui permet de diminuer la constante de temps du circuit.

Si l'on choisit de diminuer la capacité C en diminuant la largeur de grille W du transistor $Q_1$, la transconductance $G_{MO}$ diminue. Pour remplir la condition c (voir tableau II), la résistance $R_0$ de la branche de contre-réaction doit alors augmenter, ce qui entraîne que pour remplir la condition a (voir tableau II) l'impédance caractéristique Z de la ligne doit augmenter. L'augmentation de l'impédance caractéristique Z de la ligne $L_0$ peut être obtenue en diminuant la largeur de la ligne.

Lorsque l'on choisit de réaliser le circuit sur arséniure de gallium qui est un matériau particulièrement favorable à l'élaboration de circuits hyperfréquences, l'impédance caractéristique maximale qui peut être obtenue pour une ligne est de l'ordre de 100 à 120 Ω du fait des effets de bord de la ligne.

Sur ce même matériau, la limite inférieure de la valeur de la résistance R se situera vers 30 ou 40 Ω pour bien maîtriser la valeur exacte de cette résistance. En effet, tout transistor tel que $Q_1$ sur lequel la résistance R est appliquée, présente des plots de grille qui ont une résistance donnée, et la résistance R du réseau R-C doit rester grande devant la résistance du plot de grille du transistor inverseur $Q_1$.

Le circuit selon l'invention peut être réalisé soit au moyen de transistors à effet de champ du type MESFET, soit au moyen de transistors à effet de champ du type HEMT. Les seconds seront préférés pour obtenir des circuits fonctionnant à des fréquences plus élevées car leur transconductance est en moyenne deux fois plus élevée que celle des premiers transistors.

La tension de polarisation $V_1$ peut être ajustée pour faire varier la transconductance $G_M$ de l'étage inverseur. Cela permet, pour vérifier la condition C, de rattraper la valeur de la résistance de contre-réaction $R_0$ dans le cas où cette dernière différerait de la valeur optimale, par exemple du fait de la dispersion des composants lors de la mise en oeuvre du circuit.

La tension de polarisation $V_3$ est prévue pour fixer le courant de drain du transistor inverseur $Q_1$ pour ajuster le point de repos.

Selon l'invention, un déphaseur 0-90° peut en outre être réalisé à partir de la cellule unitaire passe-tout décrite précédemment. Pour réaliser ce circuit déphaseur, deux cellules du type de cette cellule passe-tout sont couplées par leur noeud d'entrée 2. Par conséquent, ce circuit déphaseur fonctionne au moyen d'un seul signal d'entrée $V_E$.

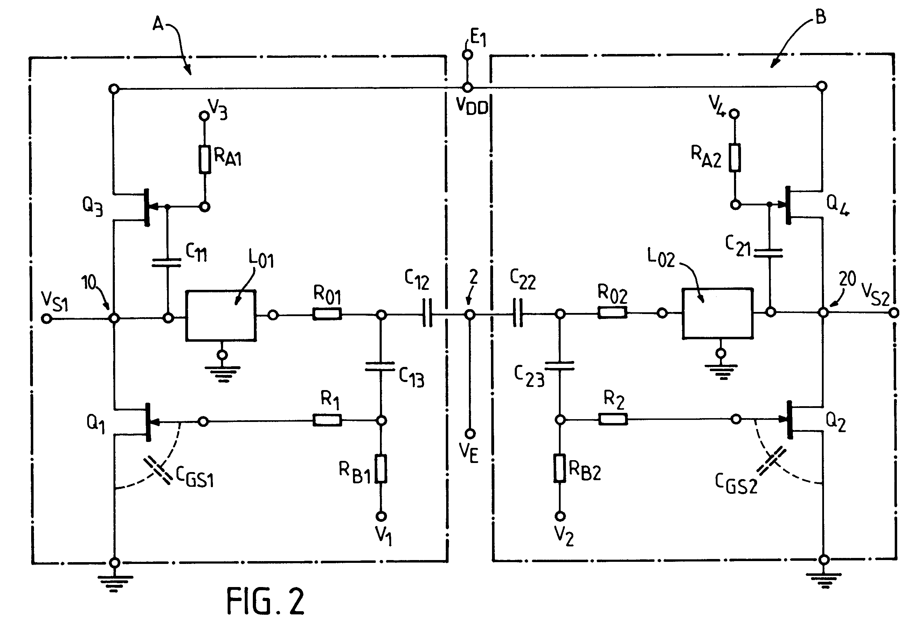

Tel que représenté sur la figure 2, ce circuit déphaseur comprend donc deux cellules respectivement A et B.

Chaque cellule comprend un transistor inverseur $Q_1$, $Q_2$ ; un transistor de charge $Q_3$, $Q_4$ ; un réseau R-C formé de la résistance $R_1$ et de la capacité grille-source $C_1 = C_{GS1}$ de $Q_1$ pour A ; un réseau R-C formé de la résistance $R_2$ et de la capacité grille source $C_2$ = $C_{GS2}$ de $Q_2$ pour B ; une branche de contre-réaction formée de la résistance $R_{01}$ et de la ligne $L_{01}$ pour A ; une branche de contre-réaction formée de la résistance $R_{02}$ et de la ligne $L_{02}$ pour B.

Dans A, pour la charge $Q_3$, la tension de polarisation de grille est $V_3$ et la résistance de polarisation de grille est $R_{A1}$, et pour l'inverseur $Q_1$ la tension de polarisation de grille est $V_1$ et la résistance de polarisation de grille est $R_{B1}$.

Dans B, la charge est $Q_4$ dont la tension de polarisation de grille est $V_4$ et la résistance de polarisation de grille est $R_{A2}$ ; et l'inverseur est $Q_2$ dont la tension de polarisation de grille est $V_2$ et la résistance de polarisation de grille est $R_{B2}$.

Les capacités d'isolement $C_1$, $C_2$, $C_3$ de la cellule unitaire décrite précédemment deviennent respectivement $C_{11}$, $C_{12}$, $C_{13}$ et $C_{21}$, $C_{22}$, $C_{23}$ dans les cellules A et B.

Les sorties $V_{S1}$ et $V_{S2}$ se font aux points 10 et 20 sur les drains des transistors inverseurs $Q_1$ et $Q_2$ respectivement.

Les valeurs des éléments de chacun des réseaux R-C dans les cellules A et B sont choisis pour fournir des constantes de temps, respectivement

$\tau_1$ et $\tau_2$

qui permettent d'obtenir, à partir du signal d'entrée hyperfréquences $V_E$ commun aux deux cellules, des signaux de sortie hyperfréquences $V_{S1}$ et $V_{S2}$ qui présentent respectivement avec l'entrée $V_E$

- un déphasage de 45° pour la cellule A
- un déphasage de 135° pour la cellule B.

Ceci est obtenu avec :

$\omega\tau_1 \simeq 0,6$

$\omega\tau_2 \simeq 3,7$.

Dans ces conditions, les sorties $V_{S1}$ et $V_{S2}$ présentent entre elles un déphasage de 90°.

Les fonctions de transfert de chacune des cellules respectivement A et B sont données par les relations 8) et 9) du tableau I. Ces fonctions montrent que l'écart d'amplitude ne dépend pas des constantes de temps des cellules.

Le tableau II rappelle les conditions a, b, c imposées aux deux cellules respectivement.

Le tableau III donne les résultats obtenus au moyen d'un circuit déphaseur selon l'invention, constitué des éléments du tableau IV c'est-à-dire réalisé avec des transistors HEMT sur arséniure de gallium.

Le tableau III donne notamment la différence d'amplitude $\Delta A$ entre les signaux $V_{S1}$ et $V_{S2}$ dans le cas où la résistance $R_0$ de contre-réaction (respectivement $R_{01}$ et $R_{02}$) a la valeur optimale de 116,75 $\Omega$ et dans les cas où, du fait de la dispersion, elle aurait la valeur de 105 $\Omega$ ou bien de 130 $\Omega$. Le tableau III donne également l'écart de phase maximal et l'écart de phase minimal correspondant auxdites valeurs de la résistance $R_0$. On constate sur ce tableau III que pour compenser l'écart sur $R_0$, on a ajusté la valeur de la tension de polarisation $V_1$ et $V_2$ respectivement.

Le tableau IV donne les valeurs optimales des composants pour réaliser le circuit selon l'invention avec des transistors du type HEMT.

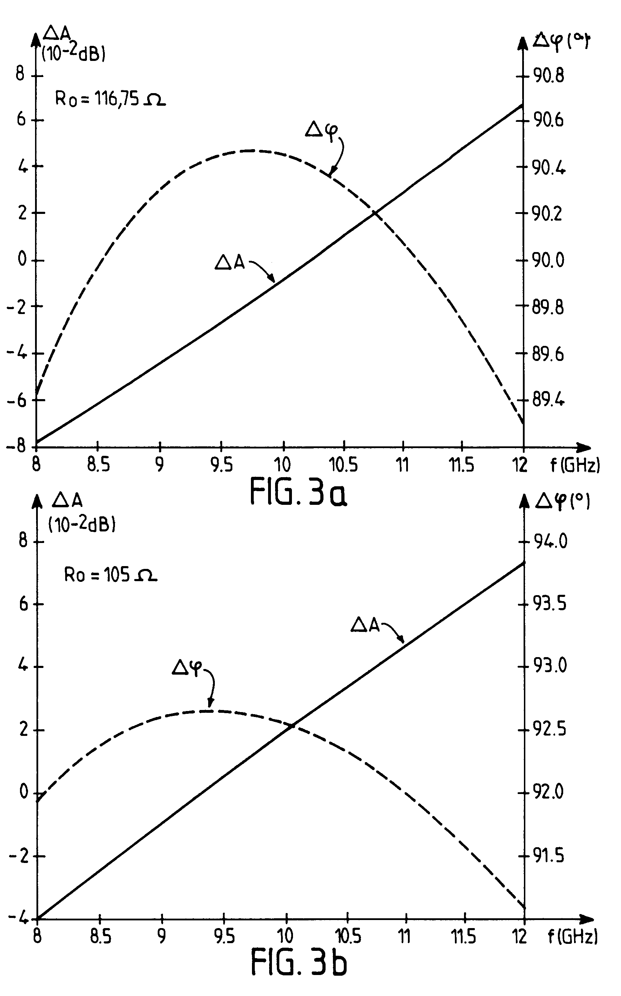

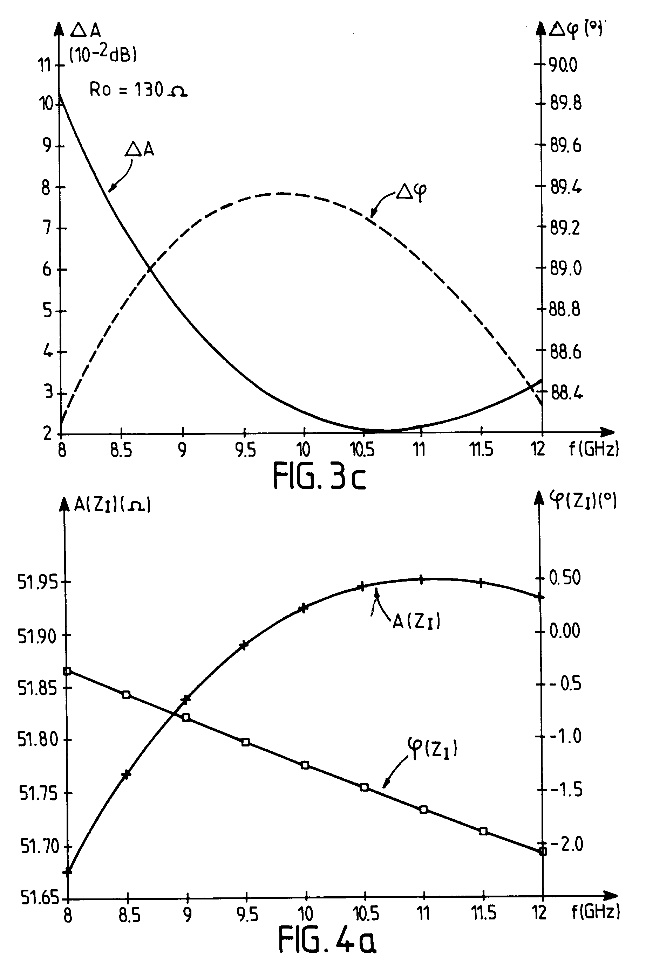

La figure 3a représente sur la courbe en trait continu, la différence d'amplitude $\Delta A$ en $10^{-2}$ dB entre les deux sorties $V_{S1}$ et $V_{S2}$ d'un déphaseur 0-90° réalisé conformément à l'invention et au moyen des composants de valeurs optimales répertoriés sur les tableaux III et IV, cette courbe étant tracée en fonction de la fréquence f en GHz ; et sur la courbe en trait discontinu, la différence de phase $\Delta\phi$ entre les signaux de la sortie $V_{S1}$ et de la sortie $V_{S2}$ également en fonction de la fréquence f en GHz.

$R_0$ = 116,75 $\Omega$.

$V_1$ = -0,23 V

$V_2$ = -0,23 V.

Cette figure 3a montre que, dans la bande de fréquences 8 à 12 GHz, et lorsque le circuit déphaseur est réalisé sur arséniure de gallium au moyen de transistors HEMT la différence de phase $\Delta\phi$ entre les deux sorties est 90° ± 0,6°, et que la différence d'amplitude $\Delta A$ est inférieure à ± 0,1 dB.

La figure 3b représente sur la courbe en trait continu, la différence d'amplitude $\Delta A$ dans les conditions où la résistance de contre-réaction $R_0$ est inférieure à la valeur optimale (voir tableau III)

$R_0$ = 105 $\Omega$

$V_1$ = -0,02 V

$V_2$ = 0,02 V

et la courbe en trait discontinu représente la différence de phase $\Delta\phi$.

Cette figure 3b montre qu'en ajustant les tensions de polarisation de grille des transistors inverseurs $Q_1$ et $Q_2$, on peut minimiser l'erreur sur la différence de phase et l'erreur sur la différence d'amplitude qui apparaissent du fait de l'erreur sur $R_0$.

Dans ces conditions, entre 8 et 12 GHz,la différence de phase était entre 91° et 92°7 ; et la différence d'amplitude était inférieure à ± 0,1 dB.

La figure 3c représente sur la courbe en trait continu, la différence d'amplitude $\Delta a$ dans les conditions où la résistance de contre-réaction $R_0$ est <u>supérieure à la valeur optimale</u> (voir tableau III)

$R_0 = 130 \ \Omega$

$V_1 = -0,360 \ V$

$V_2 = -0,440 \ V$

et la courbe en trait discontinu représente la différence de phase $\Delta\phi$.

Cette figure 3c montre qu'en ajustant les tensions de polarisation $V_1$ et $V_2$, on peut minimiser l'erreur sur la différence de phase et l'erreur sur la différence d'amplitude. Dans ces conditions, entre 8 et 12 GHz, la différence de phase $\Delta\phi$ était entre 88°2 et 89°4. La différence d'amplitude était inférieure à ± 0,1 dB.

D'une façon générale, ces résultats montrent que la fréquence de fonctionnement préférée du circuit réalisé au moyen de transistors HEMT sur arséniure de gallium sera dans la bande 8 à 12 GHz avec les composants du tableau IV. Mais en changeant les dimensions des transistors HEMT, on pourra obtenir un fonctionnement correct jusque dans la bande 10-18 GHz.

Du fait que le circuit selon l'invention, est un amplificateur à contre-réaction, le choix judicieux des éléments permet d'obtenir que l'impédance d'entrée $Z_I$ du déphaseur est de l'ordre de 50 $\Omega$, dans la bande de fréquences 8 à 12 GHz considérée dans la mise en oeuvre précédente.

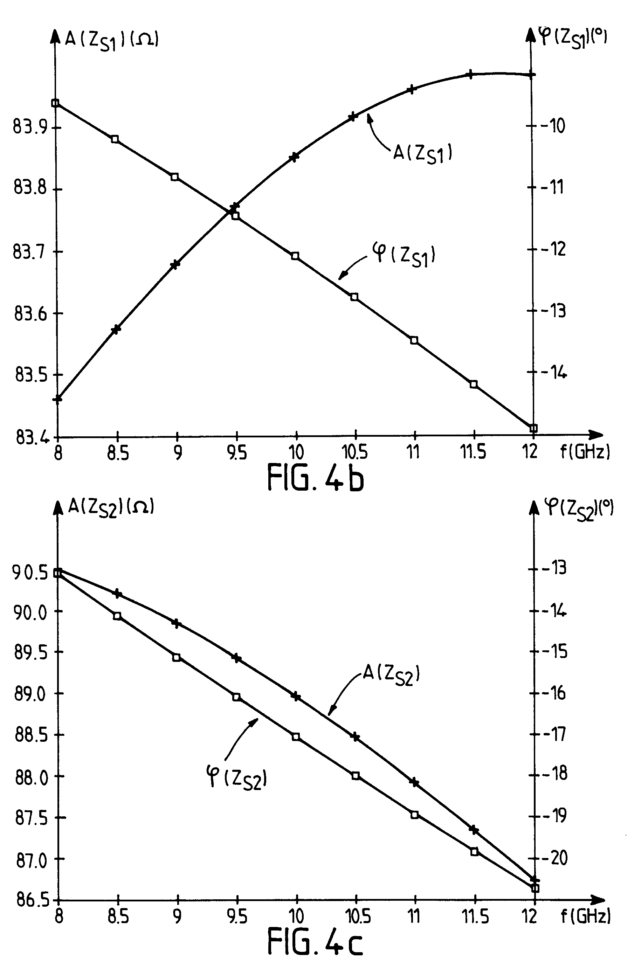

A cet effet, la figure 4a montre l'amplitude $A(Z_I)$ de l'impédance d'entrée du déphaseur dans cette mise en oeuvre, ainsi que la phase $\phi(Z_I)$ de cette impédance dans cette bande de fréquences.

Grâce au choix judicieux de ces mêmes éléments l'impédance de sortie $Z_{S1}$ de la cellule A du déphaseur et l'impédance de sortie $Z_{S2}$ de la cellule B du déphaseur restent

- entre 83 et 84 $\Omega$ pour la première
- entre 86 et 91 $\Omega$ pour la seconde.

Ainsi, les figures 4b et 4c montrent les amplitudes respectives $A(Z_{S1})$ et $A(Z_{S2})$ de ces impédances de sortie, ainsi que les phases respectives $\phi(Z_{S1})$ et $\phi(Z_{S2})$ de ces impédances toujours dans la mise en oeuvre décrite précédemment et la même bande de fréquences.

Les impédances de sortie du déphaseur sont donc de l'ordre de deux fois la valeur de l'impédance d'entrée.

Les courbes des figures 4a, 4b, 4c ont été tracées dans le cas où les valeurs des éléments du déphaseur sont optimales.

Dans une autre mise en oeuvre de l'invention, où l'on désire utiliser des transistors MESFETS, par exemple pour être en synergie de fabrication avec d'autres circuits associés, alors les fréquences maximales seront dans la bande 8 à 12 GHz.

Le tableau V donne un ensemble de caractéristiques pour réaliser le circuit selon l'invention au moyen de MESFETS. On notera que les transistors $Q_1$ et $Q_2$ des inverseurs sont à 2 doigts de grille, de préférence.

Les performances d'un tel circuit réalisé au moyen de MESFETS sont également très bonnes en ce qui concerne l'écart en amplitude et l'écart en phase des deux signaux de sortie $V_{S1}$ et $V_{S2}$.

On notera que, dans chacune des mises en oeuvre de l'invention, les transistors inverseurs $Q_1$ et $Q_2$ ont été choisis identiques pour rendre la fabrication du circuit plus aisée, de même les lignes $L_{01}$ et $L_{02}$. Ainsi le rendement de fabrication du déphaseur est amélioré.

## TABLEAU I

$$\Phi = \beta\ell = \frac{2\pi f}{v} \cdot \ell = \omega\ell/v \qquad (1)$$

$$G_M = G_{MO}\, e^{-j\omega\tau} \qquad (2)$$

$$F(j\omega) = \frac{V_S}{V_E} = -\frac{G_M(R_0\cos\Phi + jZ\,\sin\Phi)-(1+j\omega\,R\,C)}{(1+j\omega R\,C)[(G_D+Y)(R_0\cos\Phi+jZ\,\sin\Phi)+(\cos\Phi +j\frac{R_0}{Z}\sin\Phi)]} \qquad (3)$$

$$F(j\omega) = -e^{-j\Phi}\,\frac{G_{MO}R_0 e^{-j(\omega\tau-\varphi)}-(1+j\omega\,R\,C)}{[1+R_0(G_D+Y)](1+j\omega\,R\,C)} \qquad (4)$$

$$F(j\omega) = -e^{-j\Phi}\,\frac{G_{MO}}{[G_{MO}+2(G_D+Y)]}\,\frac{(1-j\omega R\,C)}{(1+j\omega R\,C)} \qquad (5)$$

$$\frac{(1-j\omega R\,C)}{(1+j\omega R\,C)} \qquad (6)$$

$$-e^{-j\Phi}\,\frac{G_{MO}}{[G_{MO}+2(G_D+Y)]} \qquad (7)$$

$$F_1(j\omega) = -e^{-j\Phi}\,\frac{G_{MO}}{[G_{MO}+2(G_D+Y)]}\,\frac{(1-j\omega\,R_1 C)}{(1+j\omega\,R_1 C)} \qquad (8)$$

$$F_2(j\omega) = -e^{-j\Phi}\,\frac{G_{MO}}{[G_{MO}+2(G_D+Y)]}\,\frac{(1-j\omega\,R_2 C)}{(1+j\omega\,R_2 C)} \qquad (9)$$

| TABLEAU II | |
|---|---|
| Condition a : | $Z = R_0$ |
| Condition b : | $\ell = \tau v$ |
| Condition c : | $R_0 = 2/G_{MO}$ |

| TABLEAU III | | | |
|---|---|---|---|
| $R_0 = R_{01} = R_{02}(\Omega)$ | 105 | Valeur optimale 116.75 | 130 |
| Différence d'amplitude $\Delta A$(dB) | -0.04 0.07 | -0.08 0.07 | 0.1 0.02 |
| Différence de phase max. $\Delta\varphi$ (degrés) Différence de phase min. | 92.7 91.1 | 90.5 89.3 | 89.4 88.2 |
| Tensions continues (Volt) | $E_1$ | 6 | 6 | 6 |
| | $V_1$ | -0.02 | -0.23 | -0.36 |
| | $V_2$ | 0.02 | -0.23 | -0.44 |
| | $V_3$ | 2.85 | 2.85 | 2.85 |
| | $V_4$ | 2.85 | 2.85 | 2.85 |

| TABLEAU IV | | | | |
|---|---|---|---|---|
| COMPOSANTS | PASSE-TOUT A | | PASSE-TOUT B | |
| Transistor type HEMT<br>Longueur de grille=$L_g$=0,6µm<br>Largeur de grille W<br>Nombre de doigts de grille N | $Q_1$<br><br>$W_1 = 70$µm<br>$N_1 = 2$ | $Q_3$<br><br>$W_3 = 50$µm<br>$N_3 = 1$ | $Q_2$<br><br>$W_2 = 70$µm<br>$N_2 = 2$ | $Q_4$<br><br>$W_4 = 50$µm<br>$N_4 = 1$ |
| RESISTANCES : | $R_{A1} = 10$ kΩ<br>$R_{B1} = 10$ kΩ<br>$R_1 = 51.9$ Ω<br>$R_{01} = 116.75$ Ω | | $R_{A2} = 10$ kΩ<br>$R_{B2} = 10$ kΩ<br>$R_2 = 394$ Ω<br>$R_{02}= 116.75$ Ω | |
| CAPACITES : | $C_{01} = 0.5$ pF<br>$C_{11} = 10$ pF<br>$C_{21} = 2$ pF | | $C_{02} = 0.5$ pF<br>$C_{12} = 10$ pF<br>$C_{22} = 2$ pF | |
| Ligne de transmission sur arséniure de gallium GaAs | Hauteur   $h = 100$ µm<br>Largeur   $W = 5$ µm<br>Longueur   $\ell = 359$ µm | | $h = 100$ µm<br>$W = 5$ µm<br>$\ell = 359$ µm | |
| Tensions continues | $E_1 = 6$ V | | | |
| | $V_1 = -0.23$ V<br>$V_3 = 2.85$ V | | $V_2 = -0.23$ V<br>$V_4 = 2.85$ V | |

| TABLEAU V | | | | |
|---|---|---|---|---|
| COMPOSANTS | PASSE-TOUT A | | PASSE-TOUT B | |
| Transistor type MESFET<br>Longueur de grille=$L_g$=0,7µm<br>Largeur de grille W<br>Nombre de doigts de grille N | $Q_1$<br><br>$W_1$ = 70µm<br>$N_1$ = 2 | $Q_3$<br><br>$W_3$ = 50µm<br>$N_3$ = 1 | $Q_2$<br><br>$W_2$ = 70µm<br>$N_2$ = 2 | $Q_4$<br><br>$W_4$ = 50µm<br>$N_4$ = 1 |
| RESISTANCES : | $R_{A1}$ = 10 kΩ<br>$R_{B1}$ = 10 kΩ<br>$R_1$ = 50 Ω<br>$R_{01}$ = 209 Ω | | $R_{A2}$ = 10 kΩ<br>$R_{B2}$ = 10 kΩ<br>$R_2$ = 400 Ω<br>$R_{02}$= 209 Ω | |
| CAPACITES : | $C_{01}$ = 0.5 pF<br>$C_{11}$ = 10 pF<br>$C_{21}$ = 2 pF | | $C_{02}$ = 0.5 pF<br>$C_{12}$ = 10 pF<br>$C_{22}$ = 2 pF | |
| Ligne de transmission sur arséniure de gallium GaAs | Hauteur: h = 100 µm<br>Largeur: W = 5 µm<br>Longueur: ℓ = 359 µm | | h = 100 µm<br>W = 5 µm<br>ℓ = 359 µm | |
| Tensions continues | $E_1$ = 6 V | | | |
| | $V_1$ = -0.23 V<br>$V_3$ = 2.85 V | | $V_2$ = -0.23 V<br>$V_4$ = 2.85 V | |

## Revendications

**1.** Circuit actif hyperfréquences du type passe-tout, comprenant un étage amplificateur et un réseau R-C, caractérisé en ce que l'étage amplificateur comprend d'abord un étage inverseur formé par un transistor à effet de champ $Q_1$ monté en inverseur, sur la grille duquel un signal d'entrée hyperfréquences $V_E$ est appliqué à travers une résistance R constituant la résistance du réseau R-C, et dont la capacité grille-source $C_{GS}$ est utilisée pour constituer la capacité C du réseau R-C, en ce que l'étage amplificateur comprend ensuite une branche de contre-réaction montée entre l'entrée hyperfréquences $V_E$ et la sortie hyperfréquences $V_S$ de l'étage inverseur, cette branche de contre-réaction incluant une résistance $R_0$ et une ligne de transmission $L_0$, et en ce que les caractéristiques des éléments de ce circuit, pour obtenir une fonction de transfert de passe-tout idéal, sont liés par les conditions :
   a) Z = $R_0$
   b) ℓ = $\tau v$

c) $R_0 = 2/G_{MO}$

où

z est l'impédance caractéristique de la ligne $L_0$

$\ell$ est la longueur physique de la ligne $L_0$

v est la vitesse de phase

$\tau$ est le temps de transit des électrons sous la grille du transistor inverseur $Q_1$

et $G_{MO}$ est la transconductance du transistor inverseur $Q_1$.

2. Circuit selon la revendication 1, caractérisé en ce que le transistor inverseur $Q_1$ est relié à une alimentation continue $E_1$ à travers une charge active formée par le transistor à effet de champ $Q_3$ dont le drain est relié à la tension continue $E_1$ dont la source est reliée au drain du transistor inverseur $Q_1$, et dont la grille est polarisée à travers une résistance $R_A$ par une tension continue $V_3$, la grille de ce transistor de charge $Q_3$ étant en outre reliée à sa source à travers une capacité $C_1$.

3. Circuit selon la revendication 2, caractérisé en ce que la grille du transistor inverseur $Q_1$ est polarisée par une tension continue $V_1$ à travers une résistance $R_B$ disposée entre $V_1$ et l'extrémité de la résistance R du réseau R-C qui reçoit l'entrée hyperfréquences $V_E$, le signal hyperfréquences $V_E$ étant appliqué sur l'extrémité de la branche de contre-réaction $R_0$, $L_0$ à travers une capacité $C_2$, et ladite extrémité de branche de contre-réaction étant reliée au point commun des résistances R et $R_B$ à travers une capacité $C_3$ et en ce que, pour remplir la condition c), une compensation de la valeur de $G_{MO}$ est obtenue par une variation de la tension de polarisation $V_1$, dans le cas où la résistance $R_0$ présente une valeur légèrement différente de sa valeur optimale.

4. Circuit selon la revendication 3, caractérisé en ce que la longueur physique $\ell$ et la largeur w de la ligne $L_0$ sont choisies pour que les conditions a) et b) soient remplies.

5. Circuit selon la revendication 4, caractérisé en ce que, la largeur de grille $W_G$ du transistor inverseur $Q_1$ est prévue pour fournir la transconductance $G_{MO}$ permettant de remplir la condition c).

6. Circuit selon la revendication 5, caractérisé en ce que la capacité grille-source $C_{GS}$ du transistor inverseur et la résistance R sont en outre prévues pour fournir une constante de temps $\tau_1$ du circuit apte à produire un déphasage de 45° entre l'entrée hyperfréquences $V_E$ et la sortie hyperfréquences $V_{S1}$ disponible sur le drain du transistor inverseur.

7. Circuit selon la revendication 5, caractérisé en ce que la capacité grille-source $C_{GS}$ du transistor inverseur et la résistance R sont en outre prévues pour founir une constante de temps $\tau_2$ du circuit apte à produire un déphasage de 135° entre l'entrée hyperfréquences $V_E$ et la sortie hyperfréquences $V_{S2}$ disponible sur le drain du transistor inverseur.

8. Circuit déphaseur pour fournir à partir d'une seule entrée hyperfréquences $V_E$, deux signaux de sortie hyperfréquences $V_{S1}$ et $V_{S2}$ présentant la même amplitude et un déphasage de 90°, ce circuit déphaseur étant constitué d'un circuit passe-tout selon la revendication 6, couplé par l'entrée $V_E$ à un circuit passe-tout selon la revendication 7.

9. Circuit selon l'une des revendications précédentes caractérisé en ce que les transistors à effet de champ sont du type choisi parmi les HEMT, ou MESFET, intégrés ainsi que les autres éléments du circuit sur un substrat en arséniure de gallium (GaAs).

10. Circuit selon la revendication 9, dans la mesure où cette dernière dépend de la revendication 8, caractérisé en ce que son impédance d'entrée est de l'ordre de 50 Ω, et en ce que l'impédance de chacune des sorties est de l'ordre du double de cette impédance d'entrée.

**Claims**

1. Active very-high frequency circuit of the all-pass type, comprising an amplifying stage ad a RC network, characterized in that the amplifying stage comprises an inverting stage formed by a field effect transistor $Q_1$ arranged as a inverter, to whose gate a very high frequency input signal $V_E$ is applied through a resistor R constituting the resistance of the RC network, and whose gate-source capacitance

$C_{GS}$ is used for constituting the capacitance C of the RC network, and in that the amplifying stage further comprises a negative feedback branch inserted between the very-high frequency input $V_E$ and a very-high frequency output $V_S$ of the inverting stage, which negative feedback branch includes a resistor $R_O$ and a transmission line $L_O$, and in that the characteristic features of the elements of this circuit are interrelated by the following conditions in order to obtain an ideal all-pass transfer function:

a) $Z - R_O$

b) $I = \tau v$

c) $R_O = 2/G_{MO}$

where Z is the characteristic impedance of the line $L_O$

I is its physical length

v is the phase velocity of propagation

$\tau$ is the transit time of the electrons under the gate of the inverting transistor Q1 and

$G_{MO}$ is the transconductance of the inverting transistor $Q_1$.

2. Circuit as claimed in Claim 1, characterized in that the inverting transistor $Q_1$ is connected to a d.c. supply point $E_1$ across an active load formed by a field effect transistor $Q_3$, whose drain is connected to the d.c. voltage $E_1$, whose source is connected to the drain of the inverting transistor $Q_1$ and whose gate is biased through a resistor $R_A$ by a d.c. voltage $V_3$, the gate of this load transistor $Q_3$ being further connected to its source across a capacitor $C_1$.

3. Circuit as claimed in Claim 2, characterized in that the gate of the inverting transistor $Q_1$ is biased by a d.c. voltage $V_1$ through a resistor $R_B$ inserted between $V_1$ and the end of the resistor R in the RC network which receives the very-high frequency input signal $V_E$, the very-high frequency input signal $V_E$ being applied to the end of the negative feedback branch $R_O$, $L_O$ across a capacitor $C_2$, and said end of the negative feedback branch being connected to the node of the resistors R and $R_B$ across a capacitor $C_3$ and in that, in order to fulfil the condition c), a compensation of the value $G_{MO}$ is obtained by a variation of the bias voltage $V_1$, in case the resistor $R_O$ has a value which is slightly different from its optimal value.

4. Circuit as claimed in Claim 3, characterized in that the physical length I and the width W of the line $L_O$ are chosen in a manner such that the conditions a) and b) are fulfilled.

5. Circuit as claimed in Claim 4, characterized in that the width $W_G$ of the gate of the inverting transistor $Q_1$ is arranged for providing the transconductance $G_{MO}$ to fulfil the condition c).

6. Circuit as claimed in Claim 5, characterized in that the gate-source capacitance $C_{GS}$ of the inverting transistor and the resistor R are furthermore arranged for providing a time constant $\tau_1$ of the network which produces a relative phase difference of 45° between the very-high frequency input signal $V_E$ and the very-high frequency output signal $V_{S1}$ available at the drain of the inverting transistor.

7. Circuit as claimed in Claim 5, characterized in that the gate-source capacitance $C_{GS}$ of the inverting transistor and the resistor R are furthermore arranged for providing a time constant $\tau_2$ of the circuit which produces a relative phase difference of 135° between the very-high frequency input signal $V_E$ and the very-high frequency output signal $V_{S2}$ available at the drain of the inverting transistor.

8. Phase-shift circuit for producing, on the basis of a single very-high frequency input Signal $V_E$, two very-high frequency output signals $V_{S1}$ and $V_{S2}$ having the same amplitude and a relative phase difference of 90°, this phase-shift circuit being constituted by an all-pass circuit as claimed in Claim 6, coupled to an all-pass circuit as claimed in Claim 7 via the input $V_E$.

9. Circuit as claimed in one of the preceding Claims, characterized in that the field effect transistors are of the HEMT or MESFET type, integrated, as are the other elements of the circuit, on a gallium arsenide substrate (GaAs).

10. Circuit as claimed in Claim 9, in so far the latter depends on Claim 8, characterized in that its input impedance is of the order of 50 Ω, and in that the impedance of each of the output signals is of the order of twice this input impedance.

**Patentansprüche**

1. Allpaßtyp-Schaltung für ultrahohe Frequenzen mit einer Verstärkerstufe und einem RC-Netz, <u>dadurch gekennzeichnet</u>, daß die Verstärkerstufe zunächst eine Umkehrstufe umfaßt, die aus einem als Inverter geschalteten Feldeffekttransistor $Q_1$ besteht, an dessen Gitter über einen Widerstand R, der den Widerstand des RC-Netzes bildet, ein Eingagssignal ultrahoher Frequenz $V_E$ angelegt wird und dessen Gitter/Source-Kapazität $C_{GS}$ als Kapazität C des RC-Netzes verwendet wird, daß die Verstärkerstufe ferner eine zwischen dem UHF-Eingang $V_E$ und dem UHF-Ausgang $V_S$ der Umkehrstufe zwischengeschaltete Gegenkopplungsleitung mit einem Widerstand $R_0$ und einer Übertragungsleitung $L_0$ umfaßt und daß zur Erreichung einer idealen Allpaß-Übertragungsfunktion die Merkmale der Elemente dieser Schaltung zueinander die folgenden Bedingungen aufweisen:

   a) $Z = R_0$

   b) $\ell = v\tau$

   c) $R_0 = 2/G_{MO}$

   wobei

   Z der Kennwiderstand der Leitung $L_0$,

   $\ell$ ihre physische Länge,

   v die Phasengeschwindigkeit,

   $\tau$ die Elektronenlaufzeit unter dem Gitter des Umkehrtransistors $Q_1$ und $G_{MO}$ die Transkonduktanz des Umkehrtransistors $Q_1$ ist.

2. Schaltung nach Anspruch 1, <u>dadurch gekennzeichnet</u>, daß der Umkehrtransistor $Q_1$ über eine Wirklast, bestehend aus dem Feldeffekttransistor $Q_3$, dessen Drainanschluß mit der Gleichspannung $E_1$ und dessen Sourceanschluß mit dem Drainanschluß des Umkehrtransistors $Q_1$ verbunden ist und dessen Gitter über einen Widerstand $R_A$ durch eine Gleichspannung $V_3$ polarisiert wird, mit einer Gleichspan-nung $E_1$ verbunden ist, wobei das Gitter dieses Lasttransistors $Q_3$ ferner über eine Kapazität $C_1$ mit einem Sourceanschluß verbunden ist.

3. Schaltung nach Anspruch 2, <u>dadurch gekennzeichnet</u>, daß das Gitter des Umkehrtransistors $Q_1$ über einen Widerstand $R_B$, der zwischen $V_1$ und dem Ende des Widerstands R des RC-Netzes, mit dem der UHF-Eingang $V_E$ verbunden ist, zwischengeschaltet ist, durch eine Gleichspannung $V_1$ polarisiert wird, wobei das UHF-Signal $V_E$ an das Ende des Gegenkopplungszweigs $R_0$, $L_0$ über eine Kapazität $C_2$ angelegt wird und das Ende des Gegenkopplungsweiges mit dem gemeinsamen Punkt der Widerstände R und $R_B$ über eine Kapazität $C_3$ verbunden ist, und daß im Hinblick auf die Erfüllung der Bedingung c) eine Anpassung des Wertes $G_{MO}$ durch Veränderung der Polarisationsspannung $V_1$ vorgenommen wird, wenn der Widerstand $R_0$ einen gegenüber dem optimalen Wert leicht abweichenden Wert aufweist.

4. Schaltung nach Anspruch 3, <u>dadurch gekennzeichnet</u>, daß die physische Lange $\ell$ und die Breite w der Leitung $L_0$ so gewählt werden, daß die Bedingungen a) und b) erfüllt sind.

5. Schaltung nach Anspruch 4, <u>dadurch gekennzeichnet</u>, daß die Gitterbreite $W_G$ des Umkehrtransistors $Q_1$ so gewählt wird, daß die sich ergebende Transkonduktanz $G_{MO}$ die Erfüllung der Bedingung c) erlaubt.

6. Schaltung nach Anspruch 5, <u>dadurch gekennzeichnet</u>, daß die Gitter/Source-Kapazität $C_{GS}$ des Umkehrtransistors und der Widerstand R ferner so gewählt werden, daß sich eine Zeitkonstante $\tau_1$ der Schaltung ergibt, die geeignet ist, eine Phasenverschiebung um 45° zwischen dem UHF-Eingang $V_E$ und dem UHF-Ausgang $V_{S1}$ an dem Drainausgang des Umkehrtransistor zu erzeugen.

7. Schaltung nach Anspruch 5, <u>dadurch gekennzeichnet</u>, daß die Gitter/Source-Kapazität $C_{GS}$ des Umkehrtransistors und der Widerstand R ferner so gewählt werden, daß sich eine Zeitkonstante $\tau_2$ der Schaltung ergibt, die geeignet ist, eine Phasenverschiebung um 135° zwischen dem UHF-Eingang $V_E$ und dem UHF-Ausgang $V_{S2}$ an dem Drainausgang des Umkehtransistor zu erzeugen.

8. Phasenschieberkreis, der ausgehend von nur einem UHF-Eingang $V_E$ zwei UHF-Ausgangssignale $V_{S1}$ und $V_{S2}$ mit gleicher Amplitude, aber um 90° verschobener Phase liefert, wobei der Phasenschieberkreis aus einer Allpaß-Schaltung nach Anspruch 6 besteht, die über den Eingag $V_E$ mit einer Allpaß-Schaltung nach Anspruch 7 gekoppelt ist.

9. Schaltung nach einem der vorhergehenden Ansprüche, dadurch gekennzeichnet, daß die Feldeffekttransistoren aus Transistoren des Typs HEMT oder MESFET gewählt und ebenso wie die anderen Bauteile der Schaltung auf einem Galliumarsenidsubstrat (GaAs) integriert werden.

10. Schaltung nach Anspruch 9, soweit dieser von Anspruch 8 abhängt, dadurch gekennzeichnet, daß ihre Eingangsimpedanz im Bereich von 50 Ω liegt und die Impedanz der Ausgänge jeweils etwa das Doppelte dieser Eingagsimpedanz beträgt.

FIG.1a

FIG. 1b

FIG. 2

FIG. 3a

FIG. 3b

FIG. 3c

FIG. 4a

FIG. 4b

FIG. 4c